# EUROPEAN PATENT APPLICATION

(11) **EP 2 398 062 A2**
(43) Date of publication of application: **21.12.2011**
(21) Application number: 11004787.5
(22) Date of filing: 10.06.2011
(51) Int. Cl.: H01L 31/0304, H01L 31/078

(54) **High efficiency InGaAsN solar cell and method of making the same**

(30) Priority: 15.06.2010 US 815541
(71) Applicant: Sharp Kabushiki Kaisha, Osaka-shi, Osaka-fu 545-8522 (JP)
(72) Inventor: Tan, Wei-Sin, Oxford OX4 4GB (GB); Sellers, Ian Robert, Oxford OX4 4GB (GB); Hooper, Stewart Edward, Oxford OX4 4GB (GB); Kauer, Matthias, Oxford OX4 4GB (GB)
(74) Representative: Müller - Hoffmann & Partner

(57) **Abstract**

An InGaAsN solar cell includes an InGaAsN structure having a bandgap between 1.0 eV to 1.05 eV, and a depletion region width of at least 500 nm.

## Description

### FIELD OF THE INVENTION

The present invention relates to an InGaAsN solar cell device, in particular with a wide depletion region width resulting in high short circuit current density. A method of making such a structure is also presented.

### BACKGROUND OF THE INVENTION

High efficiency multi-junction solar cells based on III V compound semiconductor p-n material have been proposed for space and concentrator photovoltaic applications. The solar spectrum consists of electromagnetic radiation across a whole spectrum of wavelengths, from 280 nm up to 4000 nm. A semiconductor layer absorbs photons with energy greater than its band gap and the electricity produced by a solar cell is the product of the current and voltage produced. Although a low band gap semiconductor will absorb most of the energy from the solar spectrum, a large current is generated but with low voltage, which is not desirable for many solar applications. As a result, single junction solar cells have low efficiencies.

To enable both large current and voltage generation capability, multi-junction solar cell configuration has been suggested and used. Two or more semiconductor junctions connected in series are used, whereby each junction is designed to absorb a certain portion of the energy band. The current in the series connected multi-junction solar cell is limited by the lowest current sub-cell, and the voltage generated is the sum of each sub-cell's voltages.

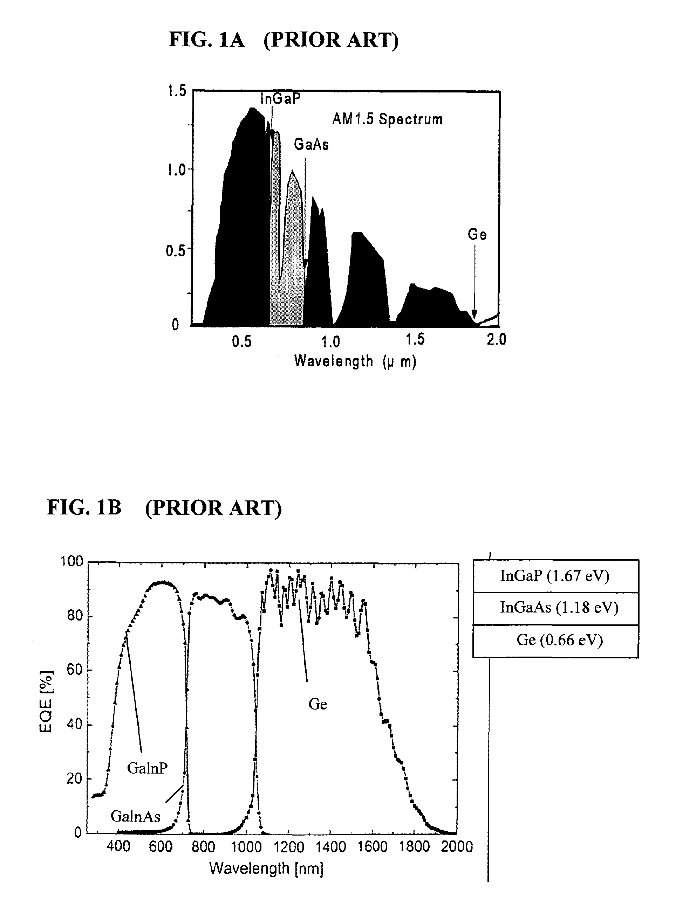

The most efficient solar cells to-date are multi-junction solar cells. Fraunhofer Institute [Applied Physics Letters, vol. 94, pp. 223504 (2009*)*] reported a 41.1% efficient cell under 454 suns concentration (31.6% efficient under one-sun) using a metamorphic Ino₆sGaₒ₃ₛP/Inoj₇Gaₒ₈₃As/Ge triple junction cell. Boeing's Spectrolab later reported a 41.6% efficient cell using a similar triple junction configuration. The AM1.5 spectrum is shown on FIG. 1A, whereby a lattice matched triple junction structure of InGaP/GaAs/Ge is used. In this configuration, excess current is generated by the Ge sub-cell, and wasted due to the current in a multi-junction cell being limited by the lowest current producing sub-cell. **FIG. 1B** shows the external quantum efficiency (EQE) from Fraunhofer Insitute whereby the short-circuit current density (Jsc) of the cell under one-sun (AM1.5d) is 16.4 mA/cm². By integrating the EQE curve of the Ge sub-cell, the Jsc achieved exceeds 25 mA/cm². Therefore, - 8mA of current is wasted from the Ge cell since the Jsc of the triple junction cell is only 16.4 mA/cm², compared to the.25 mA/cm² produced. To circumvent this effect, it has been suggested that the quarternary InGaAsN with a bandgap of - 1.0 eV 1240nm) is used for current matching in a four-junction [(InGaP/(In)GaAs/InGaAsN/Ge)] solar cell configuration (S. R. Kurtz et. al, 'Projected Performance of Three and Four Junction Devices Using GaAs and GaInP, "Proceedings of the 26th Photovoltaic Specialist Conference, Anaheim, California, Sept. 30-Oct 3 1997, pp. 875-878*),* whereby light is harvested from 873 nm - 1240 nm from the InGaAsN sub-cell. This method reduces the excess current wasted in the Ge sub-cell and the use of InGaP/GaAs/InGaAsN/Ge structure also benefits from lattice matching, thus not requiring complex buffer layers such as those used in metamorphic triple junction cells.

Despite the potential benefits of .an InGaAsN-based four-junction cell, achieving good material quality in this material system is difficult. The high defect density in this material system results in high background doping levels and short minority carrier diffusion length of < 200 nm [D. B. Jackrel, Journal of Applied Physics, vol. 101, 114916 (2007*)].*

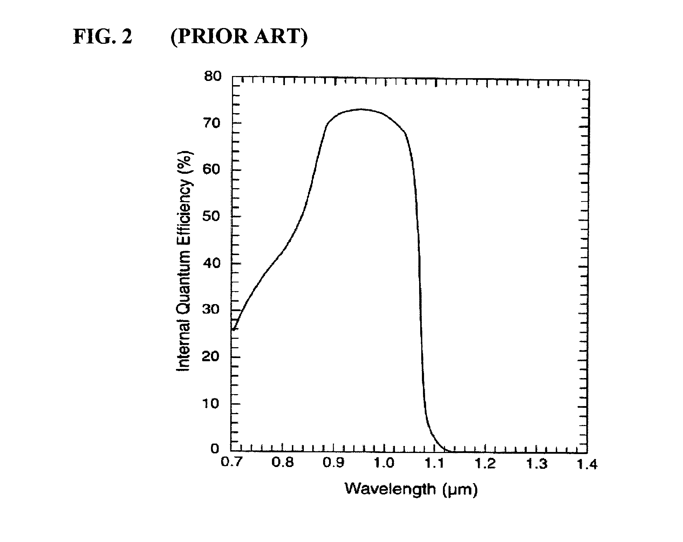

In US 6,252,287 B1 (issued June 26, 2001), S. Kurtz et al. have increased the minority carrier diffusion length in InGaAsN/GaAs heterojunctions by rapid thermal annealing the sample at 650°C - 700°C for a few minutes up to one-half hour, resulting in increased minority carrier diffusion length from 0.2 - 0.3 µm to 0.6 - 0.8 µm. FIG. 2 shows the internal quantum efficiency (IQE) achieved for a 1.13 eV InGaAsN fabricated using this method. Despite the high IQE, the 1.13 eV bandgap (λ = 1100 nm) is too large due to current matching issues in a 4 junction InGaP/GaAs/InGaAsN/Ge structure. Assuming a 4-junction cell is used, the maximum Jsc (light harvested from 873 nm - 1100 mn for AM1.SG) attainable with a 1.13 eV InGaAsN is only 11 mAlcm2, and requires an external quantum efficiency (EQE) of 100%. In order for a 4-junction cell incorporating an InGaAsN sub-cell to be feasible, the InGaAsN bandgap would have to be lower at - 1.0 eV to 1.05 eV for current matching to be possible (Jsc ~ 13.5 - 16 niAJ_{CM}² assuming 100% EQE).

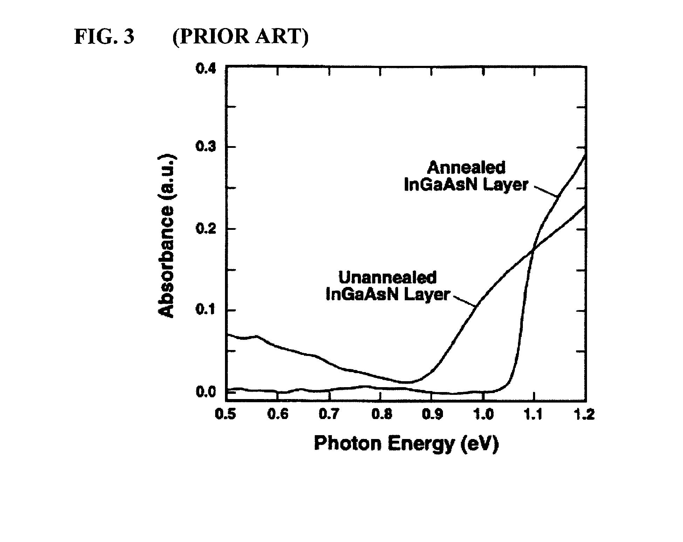

In US 5,944,913 (issued August 31, 1999), H. Q. Hou *et* al. used a metal organic chemical vapour deposition (MOCVD) grown p-n homojunction 1.05 eV InGaAsN and observed an increase in photoluminescence (PL) intensity upon in-situ annealing at 700°C - 800°C for 5-10 minutes (**FIG. 3**). No correlation is shown between the in-situ annealing methods claimed to the performance of the solar cell and the depletion region width.

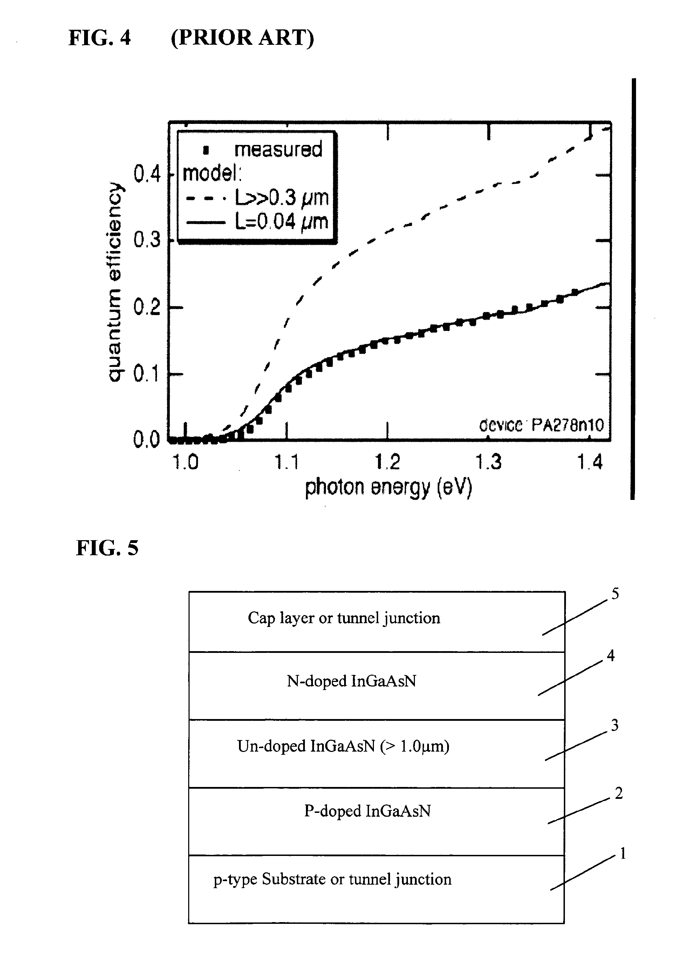

Another method to circumvent the short diffusion length in InGaAsN is by aiding the photo-generated carrier collection using a wide depletion region, whereby the effective collection length of photo-generated carriers is enhanced using the built-in electric field of the depletion region. Friedman et al. [Analysis of depletion-region collection in GaInNAs solar cells, "31s' IEEE Photovoltaics Specialist Conference, Lake Buena Vista, Florida, (2005*)]* has shown by simulation that by increasing the depletion region width, the EQE of InGaAsN samples can be enhanced (**FIG. 4**). However, the structure and method of achieving wide depletion region width is not described.

Although conventional wisdom may suggest that using a thick undoped *i*-region would result in a wide depletion region, this method has yet to produce wide depletion region width InGaAsN devices. To achieve InGaAsN with bandgaps of 1.0 eV to 1.05 eV, nitrogen (N) incorporation would have to increased to 2.5 - 3.0% (Indium content ~ 8%). However, the material quality degrades with increasing N content and leads to high background doping concentration in the i-region and subsequently narrow depletion regions. As a result, achieving wide depletion region in 1.0-1.05 eV InGaAsN material has yet to be achieved. Depletion region widths reported in the prior art are less than 500 nm.

Ptak et al. ["Enhanced depletion-width GaInNAs solar cells grown by molecular beam epitaxy, " 31" IEEE Photovoltaics Specialist Conference, Lake Buena Vista, Florida, (February 2005*)]* have used a *p-i-n* GaAs/InGaAsN heterostructure with bandgaps of 1.15 5 V and 1.28 eV and successfully achieved wide depletion region widths of 2.3 pm and 2 .7 pm respectively. Nevertheless, the bandgap of InGaAsN material at 1.15 eV remains too large and is not useful in a lattice matched 4-junction cell even if EQE of 100% is achieved. Jackrel et al. [ "Journal of Applied Physics, vol. 101, pp. 114916 (2007*)*] have used a *p-i-n* GaAs/InGaAsN heterostructures with an i-region thickness of 1-µm for band gaps of 1.03eV and 1.08 eV and achieved depletion region widths of 280nm and 370nm, respectively. Therefore, despite the thick i-region used, the depletion region width remains small at < 0.4pm.

Similarly, Friedman et al. ["GaInNAs Junctions for Next-Generation Concentrators: Progress and Prospects, " International Conference on Solar Concentrators for the Generation of Electricity or Hydrogen, Scottsdale, Arizona May 2005] achieved a depletion region width of only 500nm for a 1-u.m *i*-region *p-i-n* MOCVD-grown GaAs/InGaAsN sample. Note that no post-growth treatments were used or described in all examples given by Ptak *et* al., Jackrel *et* al. and Friedman *et* al.

Ptak et. al., [ "Effects of temperature, nitrogen ions, and antimony on wide depletion width GaInNAs, " Journal of Vacuum Science and Technology B, vol. 25 (3), (May 2007*)]* have used deflection plates and increased nitrogen flow to increase the depletion region width in a 3-um i-region 1.15 eV *p-i-n* GaAs/InGaAsN samples. Although the depletion region width was increased from 1.9 µm to 2.4 µm, the InGaAsN bandgap remains too large and is not feasible in a lattice matched 4-junction cell.

Therefore, these examples clearly indicate that achieving wide depletion region for 1.0 - 1.05 eV InGaAsN is non-trivial, and a structure and method of achieving this is required in the art. The poor minority carrier diffusion length coupled with the inability to achieve wide depletion region widths have resulted in poor Jsc achieved to-date of ~ 7mA/cm², much lower than the maximum achievable value oaf - 16 mA/cm² (light harvested from 873nm to 1240nm, AM1.SG).

The aim of the present invention is to produce an InGaAsN solar cell structure with a wide depletion region width, and high Jsc performance. A method of manufacturing for such a structure is also described.

### SUMMARY OF THE INVENTION

The present invention describes an InGaAsN solar cell structure with a bandgap of 1.0 eV - 1.05 eV, with a wide depletion region width and a method of making. The resulting device produces a high Jsc which is suitable for use in a 4-junction lattice matched solar cell.

An aspect of the invention is that for the structure to consist of an *n-i-p* InGaAsN homojunction with bandgaps of between 1.0 eV to 1.OS eV. The undoped i-region thickness of the sample is at least 1.0 pm, and has a depletion region width of at least 500 nm.

Another aspect of the invention is a structure for the wide depletion region width *n-i-p* InGaAsN homojunction to be configured in a lattice matched 4-junction solar cell.

According to another aspect of the invention, a manufacturing method for providing a wide depletion region InGaAsN layer is described, comprising the steps of ex-situ rapid thermal annealing at temperatures of between 900°C to 1000°C in N₂ ambient. The high anneal temperature increases the depletion region width to its *i*-region thickness.

According to a particular aspect of the invention, the method to achieve the wide depletion region width results in an ideality factor of - 2.0, whereby the dark current mechanism is now dominated by recombination in the space charge region.

According to an aspect of the invention, an InGaAsN solar cell is provided which includes an InGaAsN structure having a bandgap between 1.0 eV to 1.OS eV, and a depletion region width of at least 500 nm.

In accordance with another aspect, the InGaAsN structure includes a p-doped InGaAsN layer, an n-doped InGaAsN layer, and an undoped InGaAsN i-region layer disposed between the p-doped and n-doped layers. The p-doped, n-doped and i-region layers each have a bandgap between 1.0 eV to 1.05 eV.

According to yet another aspect, the i-region layer has a thickness of at least 1.0 µm.

According to another aspect, the depletion region width is at least 1.0 µm.

In accordance with still another aspect, the solar cell includes one or more additional junctions lattice matched with the InGaAsN structure.

According to another aspect of the invention, the solar cell is a lattice matched 4-junction solar cell.

According to still another aspect of the invention, a method of making an InGaAsN solar cell is provided. The method includes forming an InGaAsN structure with a bandgap between 1.0 eV to 1.OS eV, and thermally annealing the structure at a temperature of at least 900°C.

According to another aspect, the structure includes a p-doped InGaAsN layer, an n-doped InGaAsN layer, and an undoped InGaAsN i-region layer disposed between the p-doped and n-doped layers, wherein the p-doped, n-doped and i-region layers each have a bandgap between 1.0 eV to 1.05 eV.

In accordance with still another aspect of the invention, the step of thermally annealing includes ex-situ rapid thermal annealing.

According to yet another aspect, the step of thermally annealing is performed in an N₂ ambient.

In accordance with another aspect, the step of thermally annealing increases a depletion region width of the structure to at least 500 nm.

According to another aspect, the depletion region width is increased to at least 1.0 µm.

According to another aspect, the step of thermally annealing increases a depletion region width of the structure to the thickness of the i-region layer.

In accordance with yet another aspect, the structure is annealed at a temperature of between 900°C to 1000°C.

According to still another aspect, the structure is grown by molecular-beam epitaxy.

According to another aspect, the resultant solar cell has an ideality factor of approximately 2.0.

To the accomplishment of the foregoing and related ends, the invention, then, comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

In the annexed drawings, like references indicate like-parts or features:
**FIGS. 1A** and **1B** illustrate the AM 1.5 spectrum showing the one sun solar spectrum and the EQE of a metamorphic triple junction InGaP/InGaAs/Ge cell reported in the prior art;
**FIG. 2** is an IQE plot of an 1.13 eV InGaAsN solar cell as described in the prior art;
**FIG. 3** shows the absorbance versus wavelength for a 1.05 eV InGaAsN solar cell as described in the prior art;
**FIG. 4** is the simulated EQE with different depletion region widths as described in the prior art;
**FIG. 5** is the structure of a single junction *n-i-p* InGaAsN solar cell in accordance with the present invention;
**FIG. 6** is the configuration of the *n-i-p* InGaAsN structure of **FIG. 5** in a lattice matched four junction solar cell according to an exemplary embodiment of the present invention;
**FIGS. 7A** and 7B illustrate a method of making the single junction n-i p InGaAsN structure used in this invention;
**FIGS. 8** illustrate the carrier concentration versus depth profile of samples used in this invention;
**FIG. 9** is the one-sun light current-voltage plot of structures with a wide and narrow depletion region width InGaAsN cell respectively;
**FIG. 10** is the external quantum efficiency plot of structures with a wide and narrow depletion region width InGaAsN cell respectively;
**FIG. 11** is the dark current versus voltage plot of structures with a wide and narrow depletion region width InGaAsN cell respectively;
**FIGS. 12A through 12B** are the calculated efficiencies achievable in a four-junction cell using a wide and narrow depletion region width InGaAsN solar cell;

### DESCRIPTION OF THE EMBODIMENTS

The present invention provides an InGaAsN solar cell with bandgap of 1.0 eV to 1.OS eV and has a wide depletion region width. The solar cell and method of achieving the wide depletion region width is described.

**FIG. 5** shows the device structure to achieve the wide depletion region width *n-i-p* InGaAsN solar cell in accordance with the present invention. In a homojunction or single junction configuration, the layer structure begins with a p-type substrate **1,** followed by a p-doped InGaAsN base layer **2**, an undoped InGaAsN i-region layer 3 (with a thickness of at least 1-um, and peferably between 1-um to 3-µm)*,* an n-doped InGaAsN emitter layer **4,** and an *n*-doped GaAs cap layer **5**. The device structure and method of making will result in a wide depletion region of at least 1-µm. The depletion region width can be measured using a capacitance-voltage (C-V) meter at zero-bias, at an alternating current (ac) frequency of 100 kHz and ac bias of < 0. IV, for example.

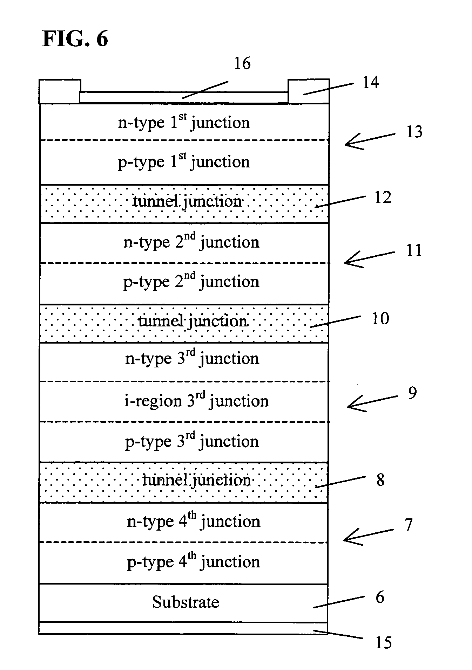

In an exemplary embodiment, the configuration of an *n-i-p* InGaAsN structure with wide depletion region width in a lattice matched 4-junction solar cell is described with reference to **FIG. 6****.** The layer structure begins with a *p*-type Germanium (Ge) substrate **6,** and a Ge n-p structure as a 4^{th} junction 7. The Ge bandgap of the 4^{th} junction **7** is 0.66 eV and harvests light from wavelengths of ~ 1240 run - 1900nm. A tunnel junction **8** or mechanically stacked method is used to connect a 3^{rd} junction **9** and the 4^{th} junction **7** in series. The wide depletion region width *n-i-p* InGaAsN structure of **FIG. 5** is used as the 3^{rd} junction **9.** The InGaAsN layers in the 3 junction **9** have a bandgap of between 1.0 eV to 1.05 eV and the i-region and depletion region width thicknesses between 1-3 µm. Light is harvested from wavelengths of between - 870 nm up to 1240 nm for this sub-cell represented by the 3^{rd} junction **9**. A tunnel junction **10** or mechanically stacked method is then used to connect the 3^{rd} junction **9** and 2^{nd} junction **11** in series. An *n-p* GaAs structure is used as the 2^{nd} junction **11.** For lattice matching, a GaAs layer with a bandgap of 1.4 eV is used, but an InGaAs layer can also be used in the case of metamorphic structures. Light is harvested from wavelengths of between - 650 nm to 870 nm for this sub-cell represented by the 2^{nd} junction **11**. A tunnel junction **12** or mechanically stacked method is used to connect the 2^{nd} junction **11** and a 1^{st} junction **13** in series. The 1^{st} junction **13** is an (Al)InGaP n-p structure **13** with a bandgap of between 1.9 to 2.0 eV, and harvests light from wavelengths of 280nm up to 650nm. Electrical contact is achieved through a top n-electrode **14** and a bottomp-electrode **15**. An anti-reflection coating **16** is typically deposited on the top surface to minimise reflections from the top layer.

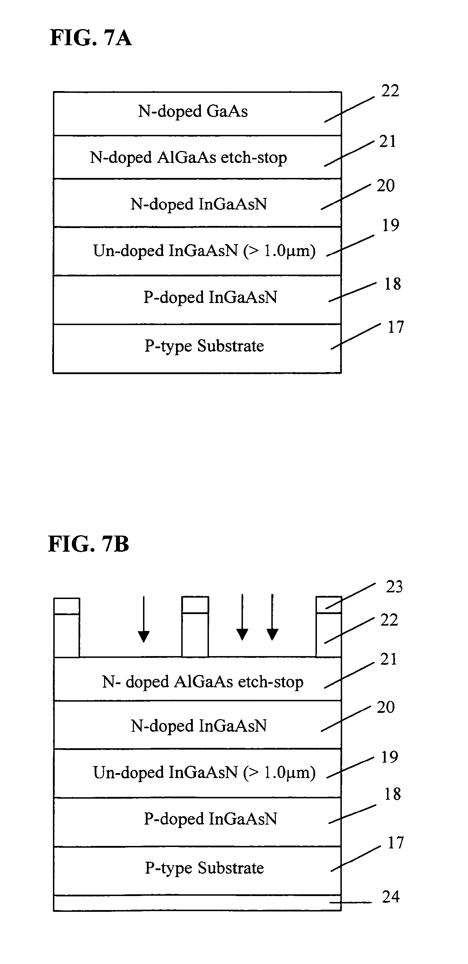

Referring now to **FIGS. 7A** and **7B****,** an exemplary method to achieve a wide depletion region using the *n-i-p* InGaAsN structure of **FIGS. 5** and **6** is described. A single junction InGaAsN cell is used for purposes of explanation to provide better clarity on the effective cell performance (**FIG. 7A**). This single junction structure may in turn be included as part of a multi-junction cell, for example as described above with respect to **FIG. 6****.** The samples used in this example are grown by molecular-beam epitaxy (MBE). Three samples are grown with different i-region thicknesses, and all other layers are grown similarly so as to have the same properties. The InGaAsN bandgaps are 1.04 eV.

With specific reference to **FIG. 7A****,** the single junction structure begins with ap-type substrate **17**, followed by a Beryllium-doped InGaAsN base layer **18** at - 500nm thick. In this exemplary embodiment, the InGaAsN layers are grown at 430°C and the GaAs layers grown at 580°C. The undoped InGaAsN *i*-region layer **19** is grown to a thickness of 500nm, 1000nm and 1400nm for samples A, B and C respectively. Next, a silicon-doped InGaAsN emitter layer **20** - 250nm thick is grown. This is followed by a 30nm thick n-doped AlGaAs etch-stop layer **21** and a 250nm thick Si-doped GaAs cap layer **22.** **FIG. 7B** shows a completed single junction InGaAsN solar cell with n-electrodes **23** and p-electrode **24**. The n-GaAs cap layer 22 has been selectively etched away from regions other than the electrode areas to minimise absorption of electromagnetic energy by the cap layer 22 itself.

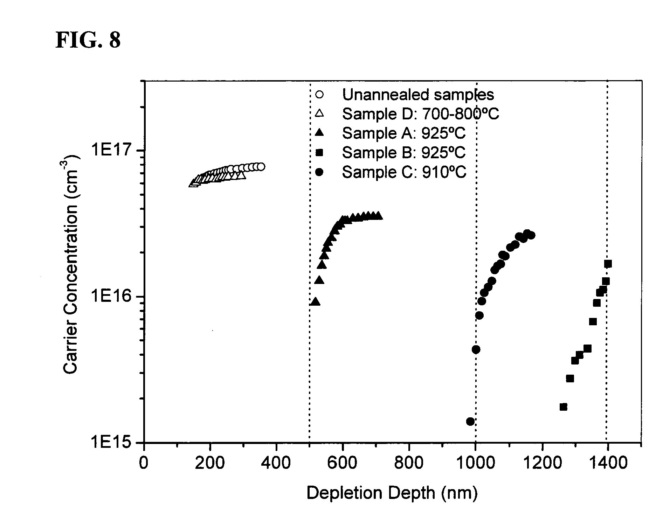

**FIG. 8** shows the carrier concentration versus depletion region width (also referred to as depth) for samples A to D. The samples are annealed ex-situ to improve the performance of the cell. Sample D represents a conventional device annealed at 825°C in N2 ambient for 30 seconds as described in the art. The depletion region width (or depth) for sample D is - 200 nm ± 50 nm, and found to be relatively unchanged regardless of the anneal temperatures between 700°C-850°C, and with varying i-region thicknesses from 500nm to 1400nm. This scenario is similar to those observed in the prior art whereby regardless of the i-region thickness, the depletion region width remains very narrow in the samples. The narrow depletion region width results in poor photo-generated carrier collection, hence Jsc performance is severely compromised.

Samples A to C are rapidly annealed at much higher temperatures >900°C for 30 seconds, and this method found to produce a wide depletion region width. Although the annealing is conducted under N₂ ambient and on pre-processed samples, this sequence is not exhaustive and can also be applied on post-processed samples. A GaAs wafer is used to cap the InGaAsN surface to prevent surface desorption at high temperatures. The key feature to achieve the wide depletion region width is the 'trigger point anneal temperature' between 900°C - 1000° anneal, whereby the depletion region width is found to extend to almost its full i-region thickness when triggered. The trigger point is found to be at 925°C for samples A and B, and 910°C for sample C, and up to 950°C in other samples. *C-V* measurements are used to determine if the trigger point has been met, whereby the depletion region width will increase thereafter. Using the invention method, the depletion region width extends upon activating the trigger point at high anneal temperatures. From **FIG. 8****,** the depletion region width is shown to increase to 500 nm, 1000 nm and 1400 nm for samples A, B and C respectively, which also corresponds with their respective i-region thicknesses. To-date, wide depletion region widths > 500 nm has yet to be achieved for narrow bandgap InGaAsN with Eg between 1.00 eV to 1.05 eV and the method taught in this invention will be useful for improving InGaAsN solar cell performance.

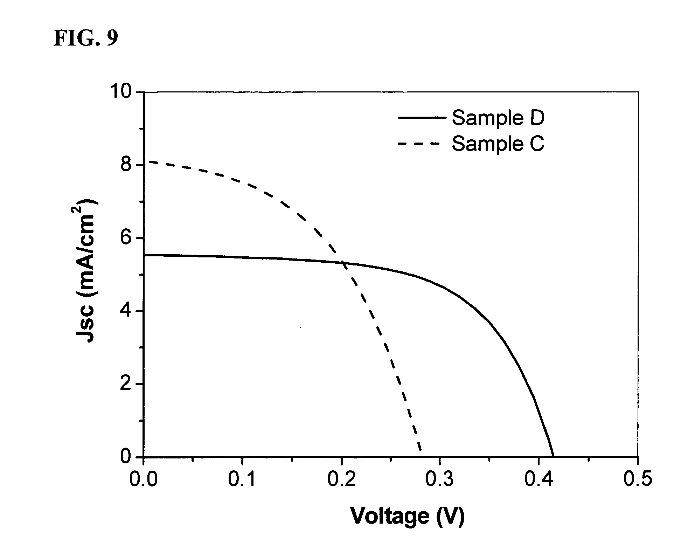

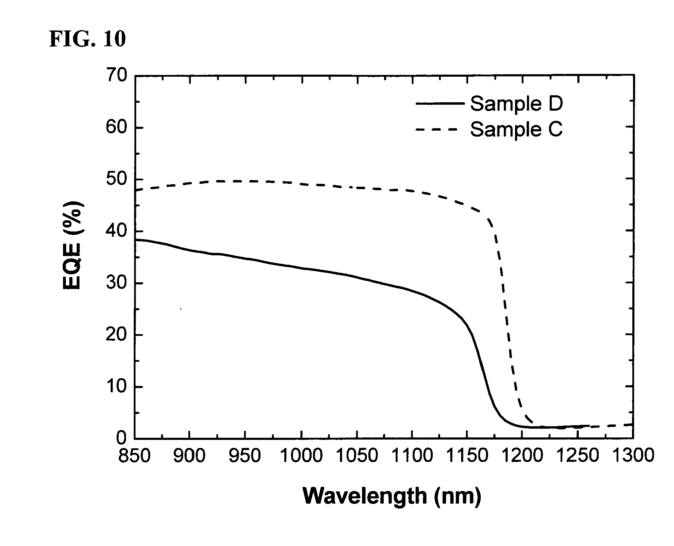

To determine the light I V performance, a commercial one-sun solar simulator under AMI.5G conditions (Total Power = 100 mA/cm²) is used. **FIG. 9** shows the light I V curve of a narrow (Wd = 200nm, Sample D) and wide depletion region width (Wd = 1400 nm, Sample C) device. The former is annealed using the conventional method described in the prior art and the latter using the invention method. No anti-reflection coating has been applied to the sample surfaces, and light reflected off the uncoated InGaAsN surface is theoretically calculated at - 30%. Hence, we can assume that the Jsc performance can be increased by - 30% if anti-reflection coating is applied. From the graph, the Jsc of Sample C and Sample D is 8.1 mA/cm and 5.5 mA/cm² respectively, and the large Jsc improvement attributed to the much wider depletion region of Sample C. The external quantum efficiency plots are shown in **FIG. 10**. A flat-top response is obtained for Sample C compared to Sample D, showing better photo-generated carrier collection across the longer wavelength regions, due its wide depletion region width properties.

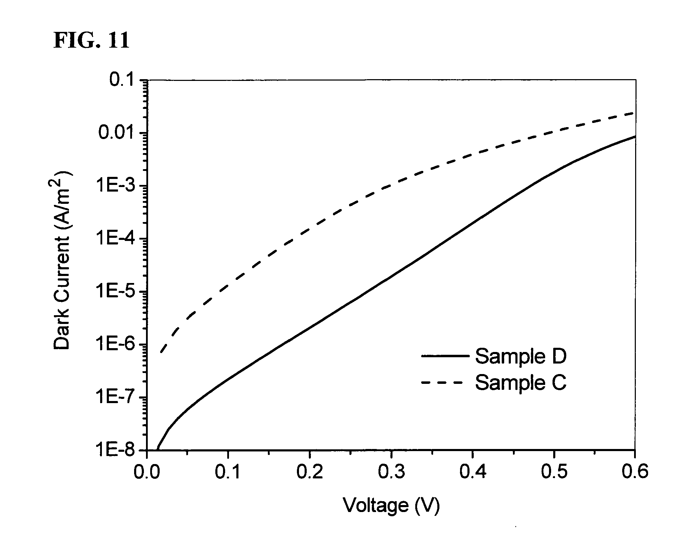

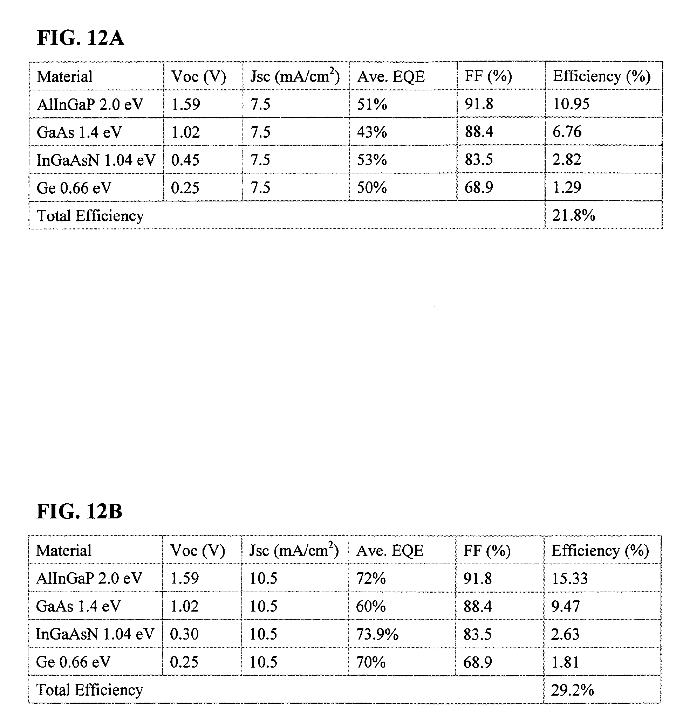

**FIG. 11** shows the dark I V curves for sample C and D. By increasing the depletion region width of Sample C, the dark currents increased as a result of increased recombination in the space charge region. The diode ideality factor n increases to ~ 2.0 for the invention method as dark currents are now dominated by space charge combination. The increase in dark currents affects the open circuit voltage (Voc) but a high Jsc is more critical in a series-connected 4-junction cell, since the current is limited by lowest current producing sub-cell. An example of the importance of high Jsc values achieved using the invention method when incorporated into a 4-junction cell is shown in **FIG. 12****.**

**FIGS. 12A through 12B** are tables describing the one-sun efficiency that can be achieved using a lattice-matched 4-junction AlInGaP/GaAs/InGaAsN/Ge solar cell. A 1.04 eV bandgap InGaAsN is used to coincide with the bandgap of sample C. For simplicity, the maximum fill factor values are used for all four sub-cells in this example, and ideal Voc values (Eg - 0.4V) used in the case of AlInGaP, GaAs and Ge cells, which are not unreasonable considering that near-ideal cells have successfully been achieved using these structures. The Jsc values are calculated based on AM1.5G, and the EQE section refers to the average EQE required to achieve the desired Jsc. **FIG. 12A and FIG. 12B** show the expected efficiency in a 4-junction cell incorporating Jsc and Voc values for sample D and sample C as the InGaAsN 3^{rd} sub-cell respectively. Note that the Jsc values were increased by 30% for both samples to take into account the fact that anti-reflective coating is not used. The efficiency for sample C is much higher since the current in other subcells are limited by the lowest current producing cell. The benefits of an InGaAsN structure with the wide depletion region width are clearly demonstrated in this case.

Although the invention has been shown and described with respect to a certain embodiment or embodiments, equivalent alterations and modifications may occur to others skilled in the art upon the reading and understanding of this specification and the annexed drawings. For example, although the present invention is described herein primarily in the context of an *n-i-p* type structure, it will be appreciated that the present invention may also be implemented in a *p-i-n* type structure. In particular regard to the various functions performed by the above described elements (components, assemblies, devices, compositions, etc.), the terms (including a reference to a "means") used to describe such elements are intended to correspond, unless otherwise indicated, to any element which performs the specified function of the described element (i.e., that is functionally equivalent), even though not structurally equivalent to the disclosed structure which performs the function in the herein exemplary embodiment or embodiments of the invention. In addition, while a particular feature of the invention may have been described above with respect to only one or more of several embodiments, such feature may be combined with one or more other features of the other embodiments, as may be desired and advantageous for any given or particular application.

### INDUSTRIAL APPLICABILITY

An InGaAsN solar cell structure with a wide depletion region width and high Jsc performance is provided. The structure is suitable for space and concentrator photovoltaic applications as well as other solar cell applications. A method of manufacturing such a structure is also provided.

## Claims

1. An InGaAsN solar cell, comprising:
an InGaAsN structure having a bandgap between 1.0 eV to 1.OS eV, and a depletion region width of at least 500 nm.

2. The solar cell according to claim 1, wherein the InGaAsN structure comprises:
a p-doped InGaAsN layer (2);
an n-doped InGaAsN layer (4); and
an undoped InGaAsN i-region layer (3) disposed between the p-doped and n-doped layers; and
wherein the p-doped, n-doped and i-region layers each have a bandgap between 1.0 eV to 1.05 eV.

3. The solar cell according to claim 2, wherein the i-region layer (3) has a thickness of at least 1.0 µm.

4. The solar cell according to any one of claims 1 thru 3, wherein the solar cell comprises one or more additional junctions (7,9,11,13) lattice matched with the InGaAsN structure.

5. The solar cell according to claim 4, wherein the solar cell is a lattice matched 4-junction solar cell.

6. A method of making an InGaAsN solar cell, comprising:
forming an InGaAsN structure with a bandgap between 1.0 eV to 1.OS eV; and
thermally annealing the structure at a temperature of at least 900°C.

7. The method according to claim 6, wherein the structure comprises:
a p-doped InGaAsN layer (18);
an n-doped InGaAsN layer (20); and
an undoped InGaAsN i-region layer (19) disposed between the p-doped and n-doped layers; and
wherein the p-doped, n-doped and i-region layers each have a bandgap between 1.0 eV to 1.05 eV.

8. The method according to any one of claims 6 thru 7, wherein the step of thermally annealing comprises ex-situ rapid thermal annealing.

9. The method according to any one of claims 6 thru 8, wherein the step of thermally annealing is performed in an N₂ ambient.

10. The method according to any one of claims 6 thru 9, wherein the step of thermally annealing increases a depletion region width of the structure to at least 500 nm.

11. The method according to any one of claims 6 thru 10, wherein the step of thermally annealing increases a depletion region width of the structure to the thickness of the i-region layer.

12. The method according to any one of claims 6 thru 11, wherein the structure is annealed at a temperature of between 900°C to 1000°C.

13. The method according to any one of claims 6 thru 12, wherein the structure is grown by molecular-beam epitaxy.

14. The method according to any one of claims 6 thru 13, wherein the resultant solar cell has an ideality factor of approximately 2.0.
